(19) Europäisches Patentamt / European Patent Office / Office européen des brevets

(11) **EP 4 293 424 A1**

(12) **EUROPEAN PATENT APPLICATION**

(43) Date of publication:
**20.12.2023 Bulletin 2023/51**

(21) Application number: **22178555.3**

(22) Date of filing: **13.06.2022**

(51) International Patent Classification (IPC):
**G03F 9/00** (2006.01)      **G03F 7/20** (2006.01)

(52) Cooperative Patent Classification (CPC):
**G03F 9/7046; G03F 7/70258**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **BUTLER, Hans**
  **5500 AH Veldhoven (NL)**
• **VAN ZON, Alexander, Martinus, Antonius**
  **5500 AH Veldhoven (NL)**

(74) Representative: **ASML Netherlands B.V.**
**Corporate Intellectual Property**
**P.O. Box 324**
**5500 AH Veldhoven (NL)**

(54) **METHOD OF SPATIALLY ALIGNING A PATTERNING DEVICE AND A SUBSTRATE**

(57)   Method of spatially aligning a patterning device and a substrate, wherein the patterning device and the substrate are separated by an optical path comprising one or more moveable optical components, the method comprising:
- projecting a radiation beam from the patterning device along the optical path;
- performing a displacement of the one or more moveable optical components along a predetermined trajectory;
- determining an optical characteristic of the radiation beam as received by a sensor on a substrate table supporting the substrate at a plurality of instants during the displacement of the one or more moveable optical components;
- spatially aligning the patterning device and the substrate based on the optical characteristic as determined at the plurality of instants.

**FIG. 6**

EP 4 293 424 A1

**Description**

FIELD

The present invention relates to a method of spatially aligning a patterning device and a substrate in a lithographic apparatus, wherein the patterning device and the substrate are separated by an optical path comprising one or more moveable optical components.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

In order to accurately pattern the substrate with the pattern of the patterning device, an accurate alignment of the substrate and the patterning device are required. In order to do so, it is known to determine an aligned position between the patterning device and a substrate, or substrate table holding the substrate, by projecting a pattern or image of one or more markers that are present on the patterning device onto a sensor arranged on the substrate table holding the substrate. Typically, such an alignment process involves projecting the pattern along an optical path which comprises one or more optical components such as mirrors or lenses. During such alignment process, the optical components are typically held in a fixed position. In case these components are or need to be displaced during a subsequent patterning or an exposure process, it has been found that the determined aligned position may be flawed or inaccurate, potentially causing an overlay error during the patterning process.

SUMMARY

It is an object of the present invention to provide an improved alignment between a patterning device and a substrate, in particular in case moveable optical components are used during a pattering process in a lithographic apparatus.

According to a first aspect of the present invention, there is provided a method of spatially aligning a patterning device and a substrate, wherein the patterning device and the substrate are separated by an optical path comprising one or more moveable optical components, the method comprising:

- projecting a radiation beam from the patterning device along the optical path;
- performing a displacement of the one or more moveable optical components along a predetermined trajectory,
- determining an optical characteristic of the radiation beam as received by a sensor on a substrate table supporting the substrate at a plurality of instants during the displacement of the one or more moveable optical components;
- spatially aligning the patterning device and the substrate based on the optical characteristic as determined at the plurality of instants.

According to a second aspect of the invention, there is provided an apparatus comprising:

- a support structure configured to support a patterning device;
- a substrate table configured to support a substrate;
- a projection system comprising a plurality op moveable optical components, the moveable optical components providing an optical path between the patterning device and the substrate;
- a positioning system configured to position the patterning device, the substrate and the moveable optical components of the projection system;
- a position measurement system configured to measure a position of the support structure, the substrate table and the moveable optical components of the projection system;
- a control unit, the control unit being configured to control the positioning system;
- wherein the apparatus is configured to receive a radiation beam to irradiate the patterning device and wherein the control unit is configured to control the apparatus to perform the method of spatially aligning the patterning device and the substrate according to the first aspect of the invention.

According to a third aspect of the invention, there is provided an apparatus comprising:

- a support structure configured to support a patterning device;
- a substrate table configured to support a substrate;
- a projection system comprising a plurality of moveable optical components, the moveable optical components providing an optical path between the patterning device and the substrate;
- a positioning system configured to position the patterning device, the substrate and the moveable optical components of the projection system;
- a position measurement system configured to measure a position of the support structure, the substrate table and the moveable optical components of the projection system;
- a control unit, the control unit being configured to control the positioning system;
- wherein the apparatus is configured to project a radiation beam from the patterning device to the substrate table supporting the substrate along the optical path, and
- wherein the control unit is configured to:

  - control the positioning system to perform a displacement of the one or more moveable optical components along a predetermined trajectory;
  - determine an optical characteristic of the radiation beam as received by a sensor on the substrate table at a plurality of instants during the displacement of the one or more moveable optical components;
  - determining an aligned position of the patterning device and the substrate, based on the optical characteristic as determined at the plurality of instants.

BRIEF DESCRIPTION OF THE DRAWINGS

Embodiments of the invention will now be described, by way of example only, with reference to the accompanying schematic drawings, in which:

- Figure 1 depicts a lithographic system according to the invention comprising a lithographic apparatus and a radiation source;

- Figure 2 depicts a system for performing the alignment method according to the invention;

- Figure 3 schematically shows a trajectory representing a displacement of a substrate table during an alignment measurement;

- Figure 4 schematically shows a 2D map of an optical characteristic as determined by a sensor during an alignment measurement;

- Figures 5a and 5b schematically show trajectories as can be applied to perform the alignment methods according to the invention;

- Figure 6 schematically shows an apparatus according to the invention.

DETAILED DESCRIPTION

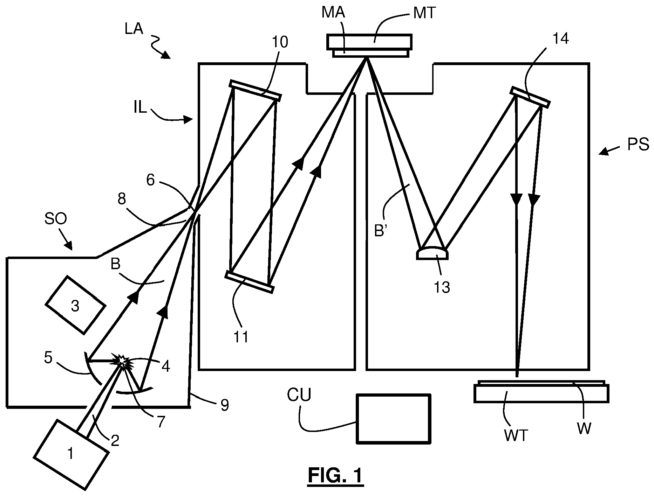

Figure 1 shows a lithographic system comprising a radiation source SO and a lithographic apparatus LA according to the invention. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.
The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. In accordance with the present invention, the mirrors 13, 14 may also be referred to as moveable optical components which can be displaced or moved, e.g. during a patterning or exposure process and during an alignment process. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

The lithographic apparatus LA as shown further comprises a control unit CU. In general, the control unit CU can be configured to control an operation of the lithographic apparatus. In particular, the control unit CU can e.g. be configured to control a positioning of the support structure MT and/or a positioning of the substrate table WT. In accordance with the present invention, the control unit CU can be configured to control the lithographic apparatus to perform a method of spatially aligning the patterning device MA and the substrate W, in accordance with the present invention. In order to do so, the control unit CU can e.g. be configured to also control a position of the mirrors 13,14 of the projection system PS. Further, as will be detailed below, the control unit CU can be configured to control a suitable positioning of the patterning device PA, the substrate table WT and the optical components of the projection system PS so as to perform a plurality of alignment measurements, whereby the moveable optical components 13, 14 of the projection system PS are arranged, for each of the alignment measurements, in predetermined positions.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a $CO_2$ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

In order to accurately pattern a substrate such as substrate W with a pattern on a patterning device such as patterning device MA, an accurate spatial alignment of the substrate and the patterning device is required. Performing an alignment process between a patterning device and an substrate is generally known and typically involves projecting a pattern or image of one or more markers that are present on the patterning device onto a sensor arranged on an object table holding the substrate. Typically, such an alignment process involves projecting the pattern along an optical path which comprises one or more optical components such as mirrors or lenses.

In a known lithographic process, the position of the optical components in the optical path are in a fixed position.

In addition, the optical components are typically also kept in said fixed position during a subsequent exposure or patterning process.

The present invention relates to determining an aligned position between a patterning device and a substrate, whereby the optical components that are arranged in an optical path between the patterning device and the substrate are movable, rather than being in a fixed position.

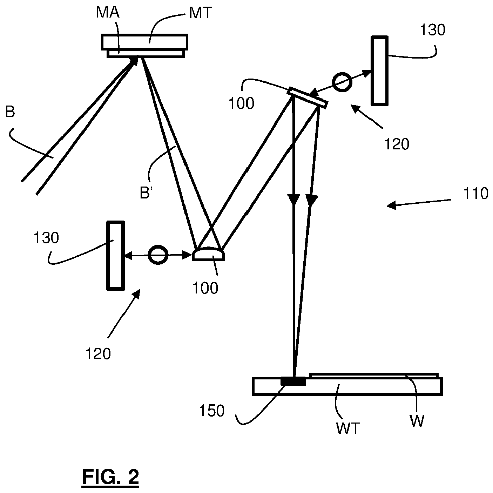

Figure 2 schematically shows an arrangement including a patterning device and a substrate wherein the present invention can be applied.

Figure 2 schematically shows a patterning device MA, arranged on a support or support structure MT, a substrate W, arranged on a substrate table WT. In the arrangement as shown, the patterning device MA is configured to receive a radiation beam B, e.g. provided by an illumination system or illuminator, and project the patterned radiation beam B', via an optical path OP, towards the substrate W or substrate table WT. In the arrangement as shown, the optical path between the pattering device MA and the substrate W comprises multiple moveable optical components 100. The set of optical components 100 may e.g. form part of a projection system 110, similar to projection system PS of Figure 1. In order to align the patterning device MA with the substrate W, or in order to determine an aligned position between the patterning device and the substrate, the patterned radiation beam B' may e.g. be patterned with a pattern or image of a marker that is present on the patterning device MA. Said patterned radiation beam B' may then be detected by an alignment sensor 150 on the substrate table WT during an alignment process, in order to establish the relative position of the patterning device MA and the substrate table WT. In case the position of the substrate W relative to the substrate table WT is also known, the aligned position between the patterning device MA and the substrate W will be known as well. In the arrangement as shown, a position of the optical components 100 is measured using a position measurement system 120 which may equally form part of the projection system 110. The position measurement system 120 may e.g. be an interferometer based measurement system or an encoder based measurement system. In the arrangement as shown, the position measurement system 120 is configured to measure a position of the optical components 100 relative to a frame 130 of the projection system 110.

In an embodiment, the position measurement system 120 can be configured to measure the position of the optical components 100 in one or more degrees of freedom. In an embodiment, the position measurement system 120 can be configured to measure a position of the optical components in 6 degrees of freedom (6 DOF). In order to do so, the position measurement system 120 can comprise multiple measurement systems. In an embodiment, the position measurement system 120 can e.g. comprise, for each optical component 100, a set of interferometers, e.g. 6 interferometers, to measure a position of the optical component in 6 DOF.

In accordance with the present invention, the projection system 110 as schematically shown in Figure 2 is intended to project, during use, a patterned beam of radiation, i.e. a radiation beam patterned by the patterning device MA, onto the substrate W. In accordance with an aspect of the present invention, the optical components 100 of the projection system 110 are configured to be displaced during the patterning or exposure process. During the pattering or exposure process an accurate alignment between the patterning device and the substrate is required in order to ensure that the patterned radiation beam is projected on the desired location on the substrate W.

It has been observed by the inventors of the present invention, that the application of the known alignment approach, whereby a spatial alignment between a patterning device and a substrate is determined while the optical components, arranged in an optical path between the patterning device and the substrate, are kept in a fixed position, does not result in an accurate alignment, in case the optical components do not have a fixed position but rather are arranged to be displaceable or moveable, in particular during a patterning or exposure process. It has been devised by the inventors that this inaccuracy in the determined alignment can be caused by an inaccuracy in the applied position measurement system 120 that is used to measure the position of the moveable optical components that are arranged in the optical path between the patterning device and the substrate.

The present invention provides a solution to mitigate this inaccuracy.

As mentioned above, the position measurement system 120 as applied to measure a position of the optical component 100 arranged in the optical path between the patterning device MA and the substrate W may have an inaccuracy. The position of an optical component 100 as measured by the position measurement system 120 may not correspond to the actual position of the optical component. Due to this error, the position of the pattern or image of the marker as projected on the substrate table WT, in particular on the alignment sensor 150, is not in the desired or expected location.

In an embodiment of the present invention, the positioning error of the moveable optical components 100 is considered caused by a cyclic error of the applied position measurement. As is generally known by the skilled person, a position measurement system, in particular an optical position measurement system such as an interferometer based measurement system or an encoder based measurement system, may suffer from what is known as a cyclic error. A cyclic error $e(x)$ of such a position measurement system can e.g. be modeled by a combination of one or more sinusoidal components, whereby the sinusoidal components have a periodicity that can be expressed as an integer fraction of the wavelength $\lambda$ as applied by the position measurement system, e.g. position measurement system 120 schematically shown in Figure 2.

As an example, a cyclic error e(x) as a function of a length x of the measurement beam of the position measurement system may be expressed as:

$$e(x) = a_1 \sin\left(\frac{2\pi}{\lambda/4}x + \phi_1\right) + a_2 \sin\left(\frac{2\pi}{\lambda/8}x + \phi_2\right) + a_3 \sin\left(\frac{2\pi}{\lambda/12}x + \phi_3\right) + a_4 \sin\left(\frac{2\pi}{\lambda/16}x + \phi_4\right)$$

$$(1)$$

In equation (1), amplitudes a1-a4 and phases $\phi$1-$\phi$4 are generally unknown. In the example given, the cyclic error e(x), which may e.g. represent the cyclic error of a position measurement system 120 measuring the position of a moveable optical component 100 in the x-direction, the cyclic error e(x) comprising 4 components. In particular, the cyclic error e(x) is described as a combination of $\lambda$/4, $\lambda$/8, $\lambda$/12 and $\lambda$/16 sinusoidal components, with $\lambda$ the wavelength of the position measurement system. In an embodiment, the wavelength $\lambda$ may e.g. be the wavelength of a laser source of the position measurement system. With respect to the amplitudes a1-a4 and phases $\phi$1-$\phi$4 of the cyclic error e(x), it can be pointed out that these parameters may be different for each component or sub-system of the position measurement system 120. As can be seen in Figure 2, the position measurement system 120 can include different components or sub-systems, each configured to measure a position of one of the moveable optical components 100. The cyclic error of the position measurement of these different components may thus have different amplitudes and/or phases.

Note that in general, a similar error equation as equation (1) can exist for each measured degree of freedom by each position measurement system. Assuming e.g. that the projection system 110 shown in Figure 2 comprises 8 moveable optical components 100 which position is measured in 6 DOF, that the positioning error of such a system can be characterized by 48 equations similar to equation (1). As such, when an alignment process would be performed with such a projection system 110 including a position measurement system having the indicated cyclic error, each degree of freedom of each optical component could suffer from a cyclic error in accordance with equation (1).

In accordance with the present invention, a method has been devised to more accurately determine the aligned position between the patterning device MA and the substrate W or substrate table WT.

According to a first aspect of the present invention, there is provided a method of spatially aligning a patterning device and a substrate, wherein the patterning device and the substrate are separated by an optical path comprising one or more moveable optical components, the method involving a displacement of one or more of the optical components along a predetermined trajectory during the alignment measurement.

In accordance with said first aspect of the present invention, rather than performing an alignment measurement having the optical components arranged in a fixed position, a method is proposed whereby, during the alignment measurement, one or more of the optical components is displaced along a predetermined trajectory.

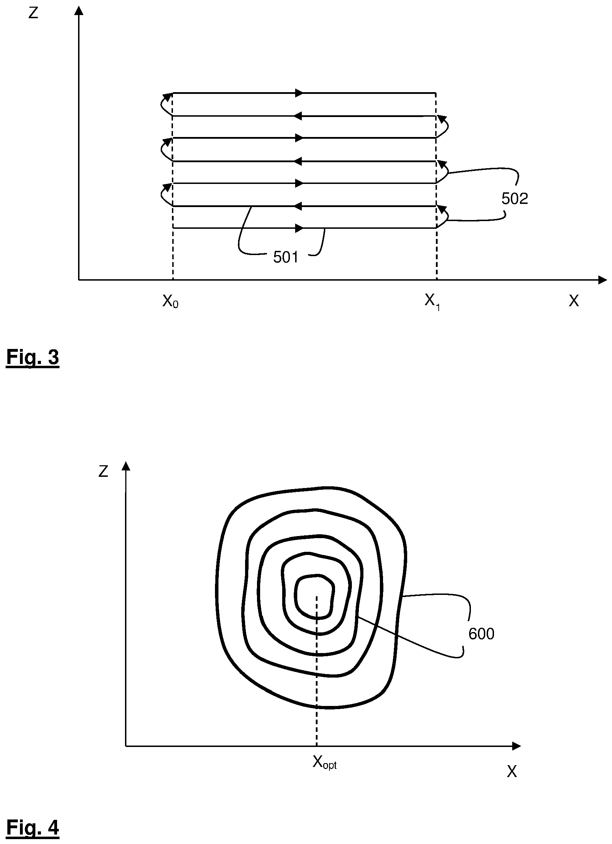

In known alignment methods, as already discussed above, an alignment position between a substrate and a patterning device is determined by projecting a radiation beam from the patterning device along the optical path towards a substrate table supporting the substrate. In particular, the projected radiation beam can e.g. be a radiation beam that is reflected from the patterning device and which contains an image of a marker on the patterning device. Said patterned radiation beam can then e.g. be projected, via the optical path containing one or more moveable optical components, towards a substrate table configured to support the substrate. In particular, the patterned radiation beam can be projected towards an alignment sensor, such as alignment sensor 150 as described above. In order to determine the aligned position, the substrate table supporting the substrate is typically displaced to cause a displacement of the substrate table relative to the radiation beam or patterned radiation beam, more specifically a displacement of the alignment sensor on the substrate table relative to the radiation beam. A typical displacement of the substrate table used to determine an aligned position of the patterning device relative to the substrate or substrate table is shown in Figure 3. Figure 3 schematically shows a trajectory, e.g. in a vertical XZ or YZ plane, representing a displacement of the substrate table during a typical alignment measurement, whereby the optical components arranged in or along the optical path are considered to be in a fixed position. Such a trajectory is also known as a warehouse scan. As can be seen, the trajectory involves displacing the substrate table over a particular range in the horizontal direction, i.e. in the X or Y direction, indicated by reference number 501, and displacing the substrate table in vertical direction or Z-direction, indicated by reference number 502, resulting in different vertical positions or Z-positions to perform the horizontal displacements or scans. During the execution of said displacement or scan, an alignment sensor may measure, at different instants, an optical characteristic of the radiation beam or patterned radiation beam impinging on the alignment sensor, e.g. alignment sensor 150. Based on the captured optical characteristic at the different instants, one can e.g. determine or derive a 2D map or matrix representing the optical characteristic. Figure 4 schematically shows such a 2D map. Figure 4 schematically shows a measured optical characteristic, e.g. an intensity, of a radiation beam as a function of an X-position and Z-position of the substrate table. Contours 600 indicate locations having the same value for the optical characteristic. Using mathematical modelling techniques such as interpolation or curve or surface fitting, an optimal value of the measured optical characteristic across the scanned area may be determined. The location at which said optimal value occurs, e.g. location $X_{opt}$ in Figure 4, may then be considered the aligned position. In particular, the position at which the optimal value of the optical characteristic occurs can be considered an aligned position of the pattering device and the alignment sensor mounted on the substrate table. Combined with data on the positioning of the substrate on the substrate table, an aligned position of the pattering device and the substrate can be determined.

In accordance with the first aspect of the invention, the one or more moveable optical components that are arranged in the optical path between the pattering device and the substrate table are not kept in a fixed position but are displaced along a predetermined trajectory during the alignment measurement. In particular, in accordance with the first aspect of the invention, at least one of the one or more moveable optical components arranged in the optical path between the pattering device and the substrate table is displaced along a predetermined trajectory during the alignment measurement.

The method of spatially aligning a patterning device and a substrate according to the first aspect of the invention comprises projecting a radiation beam from the patterning device along the optical path. Said radiation beam can e.g. be a patterned radiation beam as discussed above.

The method further comprises performing a displacement of at least one of the one or more moveable optical components along a predetermined trajectory. In an embodiment, such a displacement of the one or more moveable optical components may cause a displacement of the radiation beam relative to the substrate. As will be appreciated by the skilled person, a displacement of an optical component in an optical path between a patterning device and a substrate will typically cause a displacement of the radiation beam relative to the substrate or substrate table holding the substrate. In case of the application of a patterned radiation beam, e.g. a radiation beam comprising an image of a marker that is present on the patterning device, the aerial image of the marker will be displaced relative to the substrate or substrate table due to the displacement of the one or more moveable optical components along the optical path. Note that, within the present invention, a displacement of a moveable optical component may be a rotation, a translation or a combination thereof. Note however that when multiple optical components are each performing a displacement along a predetermined trajectory, the resulting displacement of the radiation beam along the optical path may be such that the radiation beam as impinging on the substrate table, or the aerial image of the radiation as received by the substrate table may remain substantially stationary. Based on known optical characteristics of the moveable optical components and the known geometry of the optical path, trajectories for the moveable optical components can be selected such that a movement or displacement of the moveable optical components along the selected trajectories does not causes a displacement of the radiation beam or an aerial image of the radiation beam relative to the substrate table.

The alignment method according to the first aspect of the invention further comprises determining an optical characteristic of the radiation beam as received by a sensor on a substrate table supporting the substrate at a plurality of instants during the displacement of the one or more moveable optical components. In contrast to known alignment methods, whereby the optical components along the optical path are kept at a fixed position during the measurement of an optical characteristic of the radiation beam at different instants, the method according to the first aspect of the present invention proposes to perform the multiple measurements of an optical characteristic of the radiation beam while displacing one or more moveable optical components along a predetermined trajectory. As will be explained in more detail below, an effect of a cyclic error in a position measurement of the one or more moveable optical components can be averaged out or at least mitigated by performing the multiple measurements of the optical characteristic during the displacement of the one or more moveable optical components.

Once the optical characteristic of the radiation beam is determined at the different instants, during the displacement of the one or more moveable optical components, the patterning device and the substrate can be spatially aligned based on the optical characteristic as determined at the plurality of instants. Based on the optical characteristic as determined at the plurality of instants, one can e.g. find an optimal value of the optical characteristic, said optimal value being associated with the aligned position of the patterning device and the substrate. This can e.g. be done using similar mathematical modelling techniques as discussed above, e.g. interpolation or curve or surface fitting.

The present invention aims, as already mentioned above, to provide an improved or more accurate spatial alignment of a patterning device and a substrate. In particular, the present invention aims at reducing any adverse effects on the alignment caused by measurement errors of the position measurement system or systems as applied to measure a position of the moveable optical components. An example of such measurement errors are cyclic errors.

In the alignment method according to the first aspect of the present invention, an alignment measurement is performed, during which one or more of the moveable optical components is displaced along a predetermined trajectory. It has been observed that by displacing one or more moveable optical components during the alignment measurement, an averaging out or mitigation of the effect of a cyclic error of a position measurement system associated with the optical components can be achieved.

Typically, when a moveable optical component or the like is displaced, a positioning system, e.g. comprising one or more actuators or motors, is used to cause the desired displacement. Such a positioning system typically receives, as feedback, a signal from a position measurement system indicating the position of the optical component. When a displacement of an optical component along a predetermined trajectory is to be performed, the positioning system will generate forces acting on the optical component to cause the desired displacement along the predetermined trajectory, using a position measurement signal from the position measurement system as feedback. When said position measurement signal is flawed, e.g. due to a cyclic error of the position measurement system, the actual trajectory that is followed by the optical component will deviate from the desired predetermined trajectory; the actual trajectory as followed will be affected by the cyclic error. By performing, during the displacement of the optical component, an alignment measurement, e.g. an alignment measurement comprising a warehouse scan or the like as illustrated in Figure 3, the effect of the cyclic error on the determined aligned position is averaged out or at least mitigated. As an example, the predetermined trajectory along which the one or more moveable optical components is displaced can e.g. span one or more periods of the cyclic error of the position measurement system applied to measure a position of the moveable optical components.

In an embodiment, multiple moveable optical components are displaced along respective predetermine trajectories, rather than just one optical component. Note that the selection which optical components need to be displaced may be assessed based on the impact of the cyclic error on the alignment accuracy for each optical component.

The method of spatially aligning a patterning device and a substrate according to the first aspect of the invention can be implemented in different ways.

In a first embodiment of the alignment method according to the first aspect of present invention, the predetermined trajectory along which the one or more moveable optical components is displaced is selected such that the displacement of the one or more moveable optical components causes a displacement of the radiation beam relative to the substrate table. As an example, the displacement of the one or more moveable optical components may cause a substantially horizontal displacement of an aerial image of the radiation beam relative to the substrate table. Such a horizontal displacement of an aerial image of the radiation beam relative to the substrate table may, in an embodiment of the present invention, at least partly be used instead of a horizontal displacement of the substrate table relative to the radiation beam, e.g. a horizontal displacement such as horizontal displacement 501 as indicated in Figure 3.

In a more detailed example of the first embodiment, the predetermined trajectory along which the one or more moveable optical components is displaced is selected to cause a sequence of a plurality of substantially horizontal displacements of the aerial image of the radiation beam relative to the substrate table. By doing so, the horizontal displacements of a substrate table as performed during a typical alignment measurement, as e.g. illustrated in Figure 3 by horizontal displacements 501, need not be performed by said stage. Rather, the substantially horizontal displacements required during a warehouse scan are provided by the sequence of horizontal displacements of the aerial image of the radiation beam. The sequence of substantially horizontal displacements of the aerial image of the radiation beam relative to substrate table may e.g. be configured to span a similar range as performed by the substrate table when performing a warehouse scan as illustrated in Figure 3. The sequence of horizontal displacements of the aerial image of the radiation beam relative to the substrate table may thus span the range $X_1 - X_0$ as indicated in Figure 3. The sequence of horizontal displacements may be an alternating sequence of movements or displacements in substantially opposite directions.

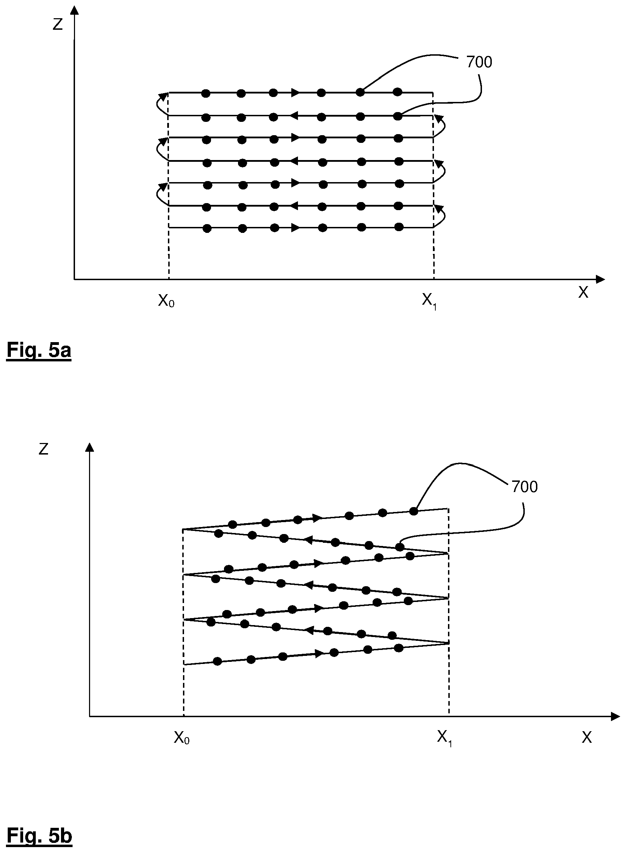

In an embodiment, the substrate table supporting the substrate may be configured to perform a substantially vertical displacement during the sequence of horizontal displacements of the aerial image of the radiation beam relative to the substrate table. Such a substantially vertical displacement may be a substantially continuous displacement or may be a discrete or stepwise displacement. In the latter case, the stepwise vertical displacements can be similar to the vertical displacements 502 as indicated in Figure 3. In such case, the resulting displacement of the radiation beam relative to the substrate table would be similar to the warehouse scan shown in Figure 3. Such a resulting displacement is schematically shown in Figure 5a. In the former case, the combination of the sequence of substantially horizontal displacements of the aerial image of the radiation beam relative to the substrate table and the substantially continuous vertical displacement of the substrate table may result in a trajectory as schematically shown in Figure 5b. Note that, regarding the trajectories shown in Figures 5a and 5b, the horizontal displacements of the trajectory are due to the displacement of the aerial image of the radiation beam whereas the vertical displacement is caused by the substrate table. In accordance with the invention, an optical characteristic of the radiation beam as received by a sensor on the substrate table is determined at a plurality of instants during the displacement of the one or more moveable optical components. In Figures 5a and 5b, the relative positions of the aerial image of the radiation beam and the substrate table at these plurality of instants are indicated by dots 700. By determining the optical characteristic of the radiation beam at the indicated positions 700, a 2D map of the optical characteristic can be made and a location corresponding to an optimum value of the optical characteristic can be determined.

In the first embodiment of the alignment method according to the first aspect of the invention, the displacement of the one or more moveable optical components is used to achieve a required horizontal displacement of an aerial image of the radiation beam relative the substrate table, such that a horizontal scanning of the substrate table, e.g. corresponding to the horizontal displacements 501 shown in Figure 3, can, at least partly be omitted.

In a second embodiment of the alignment method according to the first aspect of the present invention, the method does not rely on the displacement of the one or more moveable optical components to cause a displacement of aerial image of the radiation beam relative to the substrate table. In the second embodiment of the alignment method according to the first aspect of the present invention, the displacement of the one or more moveable optical components along a predetermined trajectory may either result in a displacement of the aerial image of the radiation beam relative to the substrate table or it may result in the radiation beam remaining stationary relative to the substrate table. In order to achieve the latter option, it may be required to displace multiple moveable optical elements along multiple predetermined trajectories and configure the displacements or trajectories such that the combined displacements of the moveable optical elements do not cause a displacement of the radiation beam or the aerial image of the radiation beam impinging on the substrate table. In such an arrangement, whereby the radiation beam remains substantially stationary relative to the substrate table, the substrate table may be configured to performing a displacement along a further predetermined trajectory, the further displacement of the substrate table causing a displacement of the substrate table relative to the radiation beam. In an embodiment, said further predetermined trajectory as performed by the substrate table may correspond to the substrate table performing a warehouse scan as e.g. shown in Figure 3, relative to the radiation beam. In such embodiment, the further predetermined trajectory can comprise a plurality of substantially horizontal displacements at a respective plurality of different vertical positions, as e.g. illustrated in Figure 3. Note however that, in accordance with the first aspect of the invention, the displacement of the substrate table along the further predetermined trajectory is performed during a displacement of one or more moveable optical components. As a result of this, a cyclic error of a position measurement system applied to measure a position of the one or more moveable optical components can be averaged out or mitigated.

In another embodiment of the first aspect of the present invention the displacement of the one or more moveable optical components is assumed to cause a displacement of an aerial image of the radiation beam relative to the substrate table. Rather than using this displacement of the aerial image of the radiation beam to perform the alignment measurement, the alignment method in this embodiment comprises performing a displacement of the substrate table which at least partly compensates or follows the displacement of the aerial image of the radiation beam relative to the substrate table as caused by the displacement of the one or more moveable optical components. In such embodiment, the substrate table may thus track the aerial image of the radiation beam as displaced due to the displacement of the one or more moveable optical components along the predetermined trajectory. In order to perform the necessary measurements of the optical characteristic, a scanning movement or displacement can be superimposed on the tracking movement. In such embodiment, the displacement of the substrate table, which can be referred to as a displacement along a further predefined trajectory can comprise the following components:

- a tracking trajectory corresponding to the displacement of the aerial image of the radiation beam relative to the substrate table as caused by the displacement of the one or more moveable optical components, and
- a scan-like trajectory during which the optical characteristic of the radiation beam as received is determined at a plurality of instants.

In an embodiment, the scan-like trajectory can be similar to the warehouse scan as schematically shown in Figure 3. The scan-like trajectory may thus comprise a plurality of substantially horizontal displacements of the substrate table at a respective plurality of different vertical positions. Alternatively, the scan-like trajectory can be similar to the trajectory shown in Figure 5b.

In an embodiment of the alignment method according to the first aspect of the invention, the predetermined trajectory followed by the one or more moveable components at least spans one period of a cyclic error of a position measurement of the moveable optical components. As discussed already in detail above, such a cyclic error can comprise multiple components, each having a different period, see e.g. equation (1). In an embodiment, the predetermined trajectory followed by the one or more moveable components spans at least one period of the cyclic error component having the longest period. In an embodiment, the predetermine trajectory spans multiple periods of the cyclic error.

For completeness it can be pointed out that, in an embodiment, a displacement of the moveable optical components may also cause a substantially vertical displacement of the aerial image of the radiation beam. In such embodiment, the displacement of the moveable optical components can at least partly replace a vertical movement of the substrate table during the alignment measurement. With reference to Figure 3, the vertical displacements of the aerial image as caused by the displacement of the moveable optical components can thus at least partly replace the vertical displacements 502 of the substrate table. In such embodiment, the vertical displacements of the aerial image relative to the substrate table or the alignment sensor can be caused by a displacement of the moveable optical components whereas the horizontal displacements of the aerial image relative to the substrate table can be caused, as explained above, by either the displacement of the substrate table, in horizontal directions, or a displacement of the moveable optical components causing a horizontal displacement of the aerial image of the radiation beam, or a combination thereof.

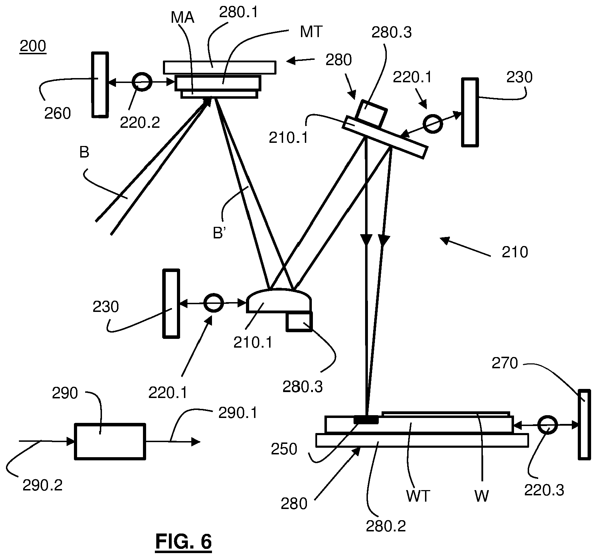

The present invention may also be embodied in an apparatus as schematically shown in Figure 6. The apparatus 200 as schematically shown in Figure 6 comprises a support or support structure MT that is configured to support a patterning device MA, a substrate table WT that is configured to support a substrate W and a projection system 210. In the arrangement as shown, the apparatus 200 is configured to receive a radiation beam B to irradiate the patterning device MA. The radiation beam B can e.g. be provided by an illumination system or illuminator. The projection system 210 of the apparatus 200 comprises a set of moveable optical components 210.1 providing an optical path between the patterning device MA to the substrate table WT or the substrate W. In order to spatially align the patterning device MA with the substrate W, or in order to determine an aligned position between the patterning device and the substrate, the patterned radiation beam B' may, during use, be patterned with a pattern or image of a marker that is present on the patterning device MA. Said patterned radiation beam B' may then be detected by an alignment sensor 150 on the substrate table WT during an alignment process, in order to establish the relative position of the patterning device MA and the substrate table WT. The apparatus 200 further comprises a position measurement system 220 that is configured to determine or measure a position of the support structure, the substrate table and the moveable optical components of the projection system 210. In the embodiment as shown, the position measurement system comprises a first system 220.1 to measure a position of the moveable optical components 210.1 relative to a frame 230 of the projection system 210. In the embodiment as shown, the position measurement system comprises a second system 220.2 to measure a position of the support system MT relative to a frame 260 of the apparatus 200. In the embodiment as shown, the position measurement system comprises a third system 220.3 to measure a position of the substrate table WT relative to a frame 270 of the projection system 210. Frames 230, 260 and 270 may be part of the same frame or may be different frames. The position measurement systems as applied may e.g. be interferometer based measurement systems or an encoder based measurement systems.

The apparatus 200 as shown further comprises a positioning system 280 configured to position the patterning device, the substrate and the moveable optical components of the projection system. In the embodiment as shown, the positioning system 280 comprises a first positioning system 280.1 to position the support structure MT that supports the patterning device. The first positioning system 280.1 can e.g. comprise one or more motors and/or actuators, e.g. electromagnetic motors or actuators to position the support structure MT and the patterning device. As an example, the first positioning system 280.1 can e.g. comprise a linear motor to provide a coarse positioning of the support structure MT and a set of actuators to provide a fine positioning of the support structure MT. The positioning system 280 further comprises a second positioning system 280.2 to position the substrate table WT that supports the substrate W. As an example, the second positioning system 280.2 can e.g. comprise a planar motor or a set of linear motors to provide a coarse positioning of the substrate table WT in a horizontal plane and a set of actuators to provide a fine positioning of the substrate table WT. Using such positioning systems 280.1 and 280.2, the patterning device MA and the substrate W may e.g. be positioned in 6 DOF.

As shown, the positioning system 280 as applied in the apparatus 200 further comprises as a third positioning system 280.3, a set of actuators 280.3 for the positioning of the moveable optical components 210.1 of the projection system 210. Such actuators 280.3 can e.g. be electromagnetic or piezo-electric actuators or a combination thereof. The actuators 280.3 can e.g. be configure to position the moveable optical components 210.1 in 6 DOF. The apparatus 200 further comprises a control unit 290 which can e.g. be embodied as a computer, controller, microcontroller or the like. The control unit 290 is configured to control the positioning system, in order to accurately position the patterning device MA, the substrate W and the moveable optical components 210.1. In order to do so, the control unit 290 can generate output signals 290.1 to control the positioning system 280, in particular the motors or actuators of the positioning system 280. To generate the output signals 290.1, the control unit 290 can be configured to receive input signals 290.2 e.g. signals obtained from the position measurement system 220, the signals 290.2 e.g. representing positions of the patterning device MT, the substrate W and the moveable optical components 210.1.

The apparatus 200 according to the present invention is further configured to perform any of the methods of spatially aligning the patterning device MT and the substrate W according to the present invention, said methods being explained in detail above.

In particular, the control unit 290 of the apparatus 200 can be configured to:

- control the positioning system 280 to perform a displacement of the one or more moveable optical components 210.1 along a predetermined trajectory;
- determine an optical characteristic of the radiation beam as received by a sensor on the substrate table at a plurality of instants during the displacement of the one or more moveable optical components; and
- determining an aligned position of the patterning device and the substrate, based on the optical characteristic as determined at the plurality of instants.

In an embodiment, the apparatus according to the invention can be incorporated in a lithographic system, such a system further comprising a radiation source and an illumination system or illuminator.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1. Method of spatially aligning a patterning device and a substrate, wherein the patterning device and the substrate are separated by an optical path comprising one or more moveable optical components, the method comprising:

   - projecting a radiation beam from the patterning device along the optical path;
   - performing a displacement of the one or more moveable optical components along a predetermined trajectory;
   - determining an optical characteristic of the radiation beam as received by a sensor on a substrate table supporting the substrate at a plurality of instants during the displacement of the one or more moveable optical components;
   - spatially aligning the patterning device and the substrate based on the optical characteristic as determined at the plurality of instants.

2. The method according to claim 1, wherein the radiation beam is a patterned radiation beam comprising a pattern of a marker arranged on the patterning device.

3. The method according to any of the preceding claims, wherein the optical characteristic is an intensity of the patterned radiation beam.

4. The method according to any of the preceding claims, further comprising:

   - performing a displacement of the substrate table along a further predetermined trajectory, the displacement of the substrate table causing a displacement of the substrate table relative to the radiation beam.

5. The method according to claim 4, wherein the displacement of the substrate table relative to the radiation beam comprises a plurality of substantially horizontal displacements at a respective plurality of different vertical positions.

6. The method according to claim 4 or 5, wherein the displacement of the one or more moveable optical components causes a displacement of an aerial image of the radiation beam relative to the substrate table, and wherein the displacement of the substrate table relative to the radiation beam at least partly compensates or follows the displacement of the aerial image of the radiation beam relative to the substrate table as caused by the displacement

EP 4 293 424 A1

of the one or more moveable optical components.

7. The method according to any preceding claim, wherein the predetermined trajectory at least spans one period of a cyclic error of a position measurement of the one or more moveable optical components.

8. The method according to any preceding claim, wherein the displacement of the one or more moveable optical components along the predetermined trajectory causes a sequence of a plurality of substantially horizontal displacements of an aerial image of the radiation beam relative to the substrate table.

9. The method according to claim 8, further comprising:

    - performing a substantially vertical displacement of the substrate table during the displacement of the one or more moveable optical components.

10. The method according to claim 9, wherein the substantially vertical displacement is a substantially continuous displacement or a step wise displacement.

11. An apparatus comprising:

    - a support structure configured to support a patterning device;
    - a substrate table configured to support a substrate;
    - a projection system comprising a plurality op moveable optical components, the moveable optical components providing an optical path between the patterning device and the substrate;
    - a positioning system configured to position the patterning device, the substrate and the moveable optical components of the projection system;
    - a position measurement system configured to measure a position of the support structure, the substrate table and the moveable optical components of the projection system;
    - a control unit, the control unit being configured to control the positioning system;
    - wherein the apparatus is configured to receive a radiation beam to irradiate the patterning device and wherein the control unit is configured to control the apparatus to perform the method of spatially aligning the patterning device and the substrate according to any of the preceding claims.

12. An apparatus comprising:

    - a support structure configured to support a patterning device;
    - a substrate table configured to support a substrate;
    - a projection system comprising a plurality of moveable optical components, the moveable optical components providing an optical path between the patterning device and the substrate;
    - a positioning system configured to position the patterning device, the substrate and the moveable optical components of the projection system;
    - a position measurement system configured to measure a position of the support structure, the substrate table and the moveable optical components of the projection system;
    - a control unit, the control unit being configured to control the positioning system;
    - wherein the apparatus is configured to project a radiation beam from the patterning device to the substrate table supporting the substrate along the optical path, and
    - wherein the control unit is configured to:

        - control the positioning system to perform a displacement of the one or more moveable optical components along a predetermined trajectory;
        - determine an optical characteristic of the radiation beam as received by a sensor on the substrate table at a plurality of instants during the displacement of the one or more moveable optical components;
        - determine an aligned position of the patterning device and the substrate, based on the optical characteristic as determined at the plurality of instants.

13. An apparatus according to claim 11 or 12, wherein the predetermined trajectory at least spans one period of a cyclic error of the position measurement system.

14. A lithographic system comprising the apparatus according to claim 11, 12 or 13 and

12

- a radiation source and an illumination system for generating the radiation beam.

15. The lithographic system according to claim 14, wherein the radiation source is an EUV radiation source and/or wherein the moveable optical components are EUV mirrors.

**FIG. 1**

**FIG. 2**

**Fig. 3**

**Fig. 4**

**Fig. 5a**

**Fig. 5b**

**FIG. 6**

Europäisches
Patentamt

European
Patent Office

Office européen
des brevets

**EUROPEAN SEARCH REPORT**

Application Number

EP 22 17 8555

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 469 348 B1 (ASML NETHERLANDS BV [NL]) 18 January 2012 (2012-01-18) | 1-3,11, 12,14,15 | INV. G03F9/00 |
| Y | * paragraphs [0023], [0026], [0042] – | 4-6,8-10 | G03F7/20 |
| A | [0056]; figures 1,2, 3a, 3b * | 7,13 | |
| X | US 2002/006561 A1 (TANIGUCHI TETSUO [JP]) 17 January 2002 (2002-01-17) | 1-3,11, 12,14 | |
| Y | * paragraphs [0020] – [0022], [0040], | 4-6,8-10 | |
| A | [0065], [0073] – [0075]; figures 1-4d * | 7,13,15 | |
| Y | US 2012/019795 A1 (POSTMA SYTSE [NL] ET AL) 26 January 2012 (2012-01-26) * paragraphs [0045] – [0049]; figures 1,4,5 * | 4-6,8-10 | |
| A | US 2019/265019 A1 (JANSEN MAARTEN JOZEF [NL] ET AL) 29 August 2019 (2019-08-29) * paragraphs [0005], [0006], [0038] – [0065] * | 7,13 | |
| A | JP 4 469609 B2 (ZYGO CORP) 26 May 2010 (2010-05-26) * paragraphs [0005], [0006], [0013], [0081] * | 7,13 | TECHNICAL FIELDS SEARCHED (IPC) G03F |
| A | EP 1 107 068 B1 (ASML NETHERLANDS BV [NL]) 18 July 2007 (2007-07-18) * paragraphs [0030] – [0036]; figures 1,2 * | 7,13 | |

The present search report has been drawn up for all claims

| Place of search | Date of completion of the search | Examiner |
|---|---|---|
| Munich | 5 December 2022 | Roesch, Guillaume |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
........................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 22 17 8555

This annex lists the patent family members relating to the patent documents cited in the above-mentioned European search report.
The members are as contained in the European Patent Office EDP file on
The European Patent Office is in no way liable for these particulars which are merely given for the purpose of information.

05-12-2022

| Patent document cited in search report | | | Publication date | Patent family member(s) | | | Publication date |
|---|---|---|---|---|---|---|---|
| EP 1469348 | B1 | | 18-01-2012 | NONE | | | |
| US 2002006561 | A1 | | 17-01-2002 | US | 6312859 | B1 | 06-11-2001 |
| | | | | US | 2002006561 | A1 | 17-01-2002 |
| US 2012019795 | A1 | | 26-01-2012 | CN | 102346376 | A | 08-02-2012 |
| | | | | JP | 5357219 | B2 | 04-12-2013 |
| | | | | JP | 2012028778 | A | 09-02-2012 |
| | | | | KR | 20120010204 | A | 02-02-2012 |
| | | | | TW | 201219990 | A | 16-05-2012 |
| | | | | US | 2012019795 | A1 | 26-01-2012 |
| US 2019265019 | A1 | | 29-08-2019 | JP | 7080293 | B2 | 03-06-2022 |
| | | | | JP | 2019527357 | A | 26-09-2019 |
| | | | | JP | 2021015304 | A | 12-02-2021 |
| | | | | JP | 2022111137 | A | 29-07-2022 |
| | | | | NL | 2019139 | A | 17-01-2018 |
| | | | | US | 2019265019 | A1 | 29-08-2019 |
| | | | | WO | 2018010961 | A1 | 18-01-2018 |
| JP 4469609 | B2 | | 26-05-2010 | JP | 4469609 | B2 | 26-05-2010 |
| | | | | JP | 2005516206 | A | 02-06-2005 |
| EP 1107068 | B1 | | 18-07-2007 | NONE | | | |

EPO FORM P0459

For more details about this annex : see Official Journal of the European Patent Office, No. 12/82